# EUROPÄISCHE PATENTSCHRIFT

(11) **EP 2 561 729 B1**
(45) Veröffentlichungstag und Bekanntmachung des Hinweises auf die Patenterteilung: **26.10.2016**
(21) Anmeldenummer: 11720030.3
(22) Anmeldetag: 21.04.2011
(51) Int. Cl.: H05K 1/18, H05K 3/46, G01L 19/06

(54) **LEITERPLATTE MIT HOHLRAUM**
PRINTED CIRCUIT BOARD WITH CAVITY
CARTE DE CIRCUIT IMPRIMÉ COMPORTANT UN ESPACE CREUX

(30) Priorität: 22.04.2010 DE 102010018499
(43) Veröffentlichungstag der Anmeldung: 27.02.2013
(73) Patentinhaber: Schweizer Electronic AG, 78713 Schramberg (DE)
(72) Erfinder: GOTTWALD, Thomas, 78655 Dunningen (DE)
(74) Vertreter: Glawe, Delfs, Moll
(86) Internationale Anmeldenummer: PCT/EP2011/002036
(87) Internationale Veröffentlichungsnummer: WO 2011/131362

(56) Entgegenhaltungen:
- EP-A1- 0 946 861
- EP-A1- 1 594 353
- EP-A1- 1 777 919
- WO-A2-2004/003991
- CN-Y- 201 434 281
- JP-A- 2009 055 490
- US-A- 6 113 407
- US-A1- 2005 018 864
- US-A1- 2005 207 114
- US-A1- 2008 070 000

## Beschreibung

### Technisches Gebiet

Die Erfindung bezieht sich auf einen Leiterplatten-Mehrschichtaufbau mit einem Hohlraum sowie ein Verfahren zum Herstellen eines solchen Leiterplatten-Mehrschichtaufbaus.

### Stand der Technik

Ein Leiterplatten-Mehrschichtaufbau umfasst in der Regel einen Schichtstapel aus mehreren übereinanderliegenden, elektrisch isolierenden bzw. dielektrischen Schichtlagen, bspw. aus einem Prepreg-Harzmaterial, mit zwischenliegenden elektrischen Leiterstrukturebenen. Der Schichtstapel wird in der Regel durch Laminieren und/oder Verpressen unter Verwendung dielektrischer Prepreg-Schichtlagen fertiggestellt, wobei zumindest ein Teil der übereinandergelegten Schichtlagen ein- oder beidseitig mit einer elektrisch leitenden Schicht versehen ist, die vor dem Übereinanderlegen zum Schichtstapel in ein gewünschtes elektrisches Leiterbild strukturiert wird.

EP 1 594 353 offenbart den Oberbegriff von Anspruch 1.

Aus der Offenlegungsschrift DE 10 2007 006 462 A1 ist eine elektronische Schaltungsanordnung mit einer ersten und zweiten Leiterplatte bekannt, wobei die erste Leiterplatte eine Aussparung aufweist und die zweite Leiterplatte derart an der ersten Leiterplatte anliegt, dass zumindest ein elektronisches Bauteil der zweiten Leiterplatte von der Aussparung der ersten Leiterplatte aufgenommen wird. Durch eine derartige Anordnung wird insgesamt eine geringere Bauhöhe der elektronischen Schaltungsanordnung erreicht.

Aus der WO 2009/036478 A3 ist ein Leiterplattenelement mit zumindest einem flexiblen Leiterplattenteil und mit zumindest einem starren Leiterplattenteil mit einem Bauelement bekannt, wobei das Bauelement in einer Kavität untergebracht ist und mit einem Lichtabgabe- oder Lichtempfangsteil über die Kante der Kavität ragt, wobei der flexible Leiterplattenteil eine flexible Schicht eines optischen, photopolymerisierbaren Materials aufweist, in der ein Lichtwellenleiter in Ausrichtung zum Lichtabgabe- oder Lichtempfangsteil des optoelektronischen Bauelements durch Bestrahlung strukturiert ist.

US 2009/0242251 A1 beschreibt ebenfalls eine Leiterplattenanordnung, welche eine Schicht umfasst, in welcher eine Kavität vorgesehen ist, in welche ein Chip eingelegt wird. Zum Fixieren des Chips innerhalb der Kavität wird ein Füllmaterial vorgesehen.

US 2009/0194831 A1 beschreibt eine integrierte Drucksensoranordnung, welche eine bedruckte Leiterplattenanordnung mit einer Mehrzahl von Baugruppen umfasst. Der Drucksensor ist dabei auf einen Keil der Leiterplattenanordnung montiert. Die Leiterplattenanordnung umfasst ferner mindestens einen Druckübertragungskanal und einen elektrischen Übertragungskanal.

US 2009/0071705 A1 beschreibt eine Leiterplattenanordnung mit integrierten Bauelementen, wobei die Leiterplattenanordnung eine dielektrische Schicht mit einer auf einer Seite ausgebildeten Kavität umfasst. Eine Komponente ist in die Kavität eingeführt, so dass eine Elektrode dieser Komponente einer Seite der dielektrischen Schicht gegenüber steht. Eine zweite Komponente ist auf eine Seite der ersten Komponente aufgebracht, in der Gestalt, dans eine Elektrode der zweiten Komponente in die gleiche Richtung weist wie die Elektrode der ersten Komponente. Dadurch kann eine Leiterplattenanordnung hergestellt werden, in welcher eine Mehrzahl von Komponenten mit unterschiedlichen Dicken eingebettet werden kann.

Aus der US 2009/0040704 A1 ist eine Leiterplatte bekannt, welche eine Kernschicht, eine isolierende Schicht auf der Kernschicht und eine Kavität, ausgebildet auf einem Teil der isolierenden Schicht, umfasst, wobei eine Leiterstruktur auf der isolierenden Schicht ausgebildet ist und die Leiterstruktur ein oder mehrere externe Anschlüsse oberhalb der Kavität aufweist. Die Kavität ist vorgesehen, um dem externen Anschluss zum Anschluss einer externen Apparatur eine gewisse Flexibilität und Elastizität zu verleihen.

Aus der US 2008/0296056 A1 ist ebenfalls eine Leiterplattenanordnung bekannt, welche eine Kavität aufweist, wobei innerhalb der Kavität eine Mehrzahl von Erhöhungen vorgesehen ist, welche als elektrische Verbindungen dienen und gegeneinander durch ein isolierendes Material abgeschirmt sind.

US 2008/0052906 A1 und US 2008/0102410 A1 offenbaren ebenfalls Leiterplattenanordnungen, welche eine Kavität aufweisen, wobei die Kavität dazu genutzt wird, Bauelemente der Leiterplattenanordnung aufzunehmen, um dadurch möglichst dünne Leiterplattenstrukturen bilden zu können.

Aus dem Stand der Technik ist es jedoch nicht bekannt, bei Vorsehen einer derartigen Kavität in einer Leiterplattenanordnung, den dort herrschenden Druck gezielt zu berücksichtigen bzw. die Kavität zu nutzen, Druckverhältnisse zu schaffen, die eine spezifische Anwendung der Leiterplattenstruktur erlauben, wie bspw. ein raumeffizientes Vorsehen eines Drucksensors innerhalb der Kavität oder die Ausbildung einer effizienten und kostengünstigen Hochfrequenz-Koppelstruktur.

### Zusammenfassung der Erfindung

Unter dem Begriff Leiterplatten-Mehrschichtaufbau ist im Rahmen der vorliegenden Erfindung jede Art von zwei- oder mehrschichtigem Aufbau mit mindestens einer Ebene einer Leiterbildstruktur zu verstehen. Dabei sind bspw. bestückte oder nichtbestückte Leiterplatten bzw. Leiterplattenteile, Multilayerstrukturen und sog. Interposer zur Verwendung als Bauteileträger in vorgefertigten Mehrschicht-Leiterplattenstrukturen umfasst.

Die vorliegende Erfindung stellt einen Leiterplatten-Mehrschichtaufbau mit einem Schichtstapel aus mehreren übereinander angeordneten, elektrisch isolierenden und/oder leitenden Schichten, und einem Hohlraum im Inneren des Schichtstapels bereit, wobei der Hohlraum sich lateral nur in einem Teilbereich der Flächenausdehnung des Schichtstapels erstreckt, durch eine in dem Schichtstapel vorgesehene Öffnung einem den Leiterplatten-Mehrschichtaufbau umgebenden Druck ausgesetzt ist und gegenüber einem Flüssigkeitseintritt abgedichtet ist.

Gemäß einer möglichen Ausführungsform ist vorgesehen, dass in dem Hohlraum ein Sensor, insbesondere ein Drucksensor angeordnet ist. Der Drucksensor kann einen Umgebungsdruck nur messen, wenn ein Druckausgleich zwischen Umgebung und dem Inneren des Leiterplatten-Mehrschichtaufbaus geschaffen wird, was nur dadurch möglich wird, dass in dem Schichtstapel eine Öffnung vorgesehen wird, die einen Druckausgleich zwischen einem den Leiterplatten-Mehrschichtaufbau umgebenden Außenbereich und dem gebildeten Hohlraum schafft. Dabei ist anzumerken, dass allein ein im Inneren des Leiterplatten-Mehrschichtaufbaus geschaffenes Loch spezifische Anforderungen für einen darin vorgesehenen Drucksensor nicht erfüllt, da der Leiterplatten-Mehrschichtaufbau nach einer Vereinzelung in der Regel gewaschen werden muss bzw. teilweise auch nach Bestückung gewaschen wird, wobei Flüssigkeit in einen durch ein einfaches Loch gebildeten Hohlraum eindringen würde, die dann nicht mehr entfernt werden könnte. Aufgrund dessen ist es erfindungsgemäß vorgesehen, den gebildeten Hohlraum gegenüber einem Flüssigkeitseintritt abzudichten.

Gemäß einer möglichen Ausführungsform des erfindungsgemäß vorgesehenen Leiterplatten-Mehrschichtaufbaus ist der Hohlraum dadurch erzeugt, dass durch Fräsen oder Stanzen einer Innenlage oder eines Multilayerkerns eine Ausnehmung oder ein Loch erzeugt wird und durch Verpressen mit weiteren Innenlagen, Prepreg-Schichtlagen oder Multilayerkernen die Ausnehmung einseitig bzw. das Loch beidseitig bis auf die vorzusehende Öffnung verschlossen wird.

Dabei ist es ferner möglich, dass bei Bildung des Hohlraums zunächst ein Durchgangsloch oder eine Tiefenfräsung ausgeführt werden. Bei Vorsehen eines Durchgangslochs ist dann ein beidseitiges Abdecken erforderlich, während bei Vorsehen einer Tiefenfräsung lediglich eine einseitige Abdeckung vonnöten ist, um den so gebildeten Hohlraum gegenüber einem Flüssigkeitseintritt abzudichten. Bei Verwendung eines Interposers kann eine Seite eines Durchgangsloch durch den Interposer verschlossen werden.

Zur Abdichtung gegenüber einem Flüssigkeitseintritt ist es ferner denkbar, den Hohlraum zumindest auf einer Seite mit Hilfe mindestens einer flüssigkeitsundurchlässigen Membran abzudecken.

Die zur Abdichtung dienende Membran ist nur partiell in den Leiterplatten-Mehrschichtaufbau eingebracht. Das bedeutet, dass dabei die mindestens eine Membran nur partiell über die Flächenausdehnung des Schichtstapels in dem Schichtstapel des Leiterplatten-Mehrschichtaufbaus eingebracht ist, wobei die Membran sich zumindest soweit über die Flächenausdehnung des Schichtstapels erstreckt, dass durch sie eine Abdichtung des Hohlraums gegenüber Flüssigkeitseintritt realisiert ist.

Die Membran kann bspw. durch Einlaminieren zwischen sogenannten No-Flow-Prepreg-Schichten erfolgen, oder sie kann auf eine Innenlage, bspw. auf eine äußere Deckelschicht dicht bzw. haftfest geklebt sein.

Die zur Abdichtung dienende Membran kann bspw. aus mikroporösem PTFE, insbesondere aus Goretex bestehen, das eine Gasdiffusion ermöglicht, einen Flüssigkeitszutritt jedoch ausschließt. Die Membran kann alternativ auch aus einem PEEK oder einem Polyimid oder einem Gemisch der genannten Materialien bestehen. Das für die Membran verwendete Material ist so gewählt, dass es haftfest geklebt oder einlaminiert werden kann und beständig gegen verwendete Medien oder Verarbeitungstemperaturen ist.

Durch Variation der Größe und Dicke der eingesetzten Membran können trägere oder schnellere Messungen des herrschenden Drucks bei Vorsehen eines Drucksensors innerhalb des Hohlraums ermöglicht werden. Eine dünne Membran verhält sich in der Regel elastisch, und es bedarf bei schnellen Druckwechseln keiner Diffusion. Demgegenüber wird sich bei dicken, unelastischen Membranen ein Druckausgleich erst mit einer diffusionsbedingten Verzögerung einstellen.

Ein erfindungsgemäß vorgesehener Leiterplatten-Mehrschichtaufbau kann in einer weiteren Ausführungsform als HF-Koppelstruktur ausgebildet sein. Der erfindungsgemäß vorgesehene Leiterplatten-Mehrschichtaufbau mit einem Hohlraum eignet sich gut für eine Bestückung der Leiterplatte mit Komponenten oder für Anwendungen in der Hochfrequenztechnik. Da der vorgesehene Hohlraum im wesentlichen Luft mit einer materialspezifischen relativen Dielektrizitätskonstante von nahe 1 enthält, ermöglicht der Hohlraum, bspw. Hochfrequenz, von Schicht zu Schicht verlustarm einzukoppeln bzw. zu übertragen. Dabei kann in der Regel teures Hochfrequenz-Material für einen Gesamtaufbau einer Leiterplatte eingespart werden und kostengünstige Mischaufbauten unter Verwendung von Standard-FR-4 können realisiert werden.

Ferner kann in einer weiteren Ausführungsform des erfindungsgemäß vorgesehenen Leiterplatten-Mehrschichtaufbaus vorgesehen sein, in den Hohlraum einen SAW-Filter einzusetzen, so dass der Hohlraum quasi als Gehäuse für den SAW-Filter dient, und somit der SAW-Filter keinen physikalischen Kontakt mit einem ihn umgebenden Harz-Material hat, so dass er als Wellenfilter optimal fungieren kann. SAW-Filter basieren auf Interferenz von Signalen verschiedener Laufzeit, was mit dem Piezoeffekt realisiert ist. Ein SAW-Filter (Surface Acoustic Wave) wird auch als Oberflächenwellenfilter bezeichnet und entspricht einem Bandpassfilter für elektronische Signale mit einer geringen Bandbreite von wenigen MHz.

Ferner umfasst die vorliegende Erfindung ein Verfahren zum Herstellen eines erfindungsgemäßen Leiterplatten-Mehrschichtaufbaus. Das Verfahren umfasst dabei mindestens folgende Schritte:
- Bereitstellen einer Innenlage oder eines MultilayerKerns,
- Erzeugen einer Ausnehmung in der Innenlage oder dem Multilayerkern,
- Anordnen der weiteren Schichten des Schichtstapels unterhalb und/oder oberhalb der mit der Ausnehmung versehenen Innenlage bzw. des mit der Ausnehmung versehenen Multilayerkerns, wodurch ein Hohlraum im Inneren des Schichtstapels gebildet wird, der sich lateral nur in einem Teilbereich der Flächenausdehnung des Schichtstapels erstreckt,
- Zusammenlaminieren und/oder Verpressen der so erhaltenen Mehrschichtanordnung,
- Jeweiliges Vorsehen mindestens einer Öffnung in einer oder mehreren Schichten der den Schichtstapel bildenden Schichten, so dass der gebildete Hohlraum einem den Leiterplatten-Mehrschichtaufbau umgebenden Druck ausgesetzt ist, und
- Abdichten des gebildeten Hohlraums gegenüber einem Flüssigkeitseintritt durch Einlaminieren mindestens einer flüssigkeitsundurchlässigen Membran (9) zwischen Schichtlagen, insbesondere zwischen No-Flow-Prepreg Schichtlagen oder durch dichtes/haftfestes Kleben der mindestens einen flüssigkeitsundurchlässigen Membran (9) auf eine Innenlage, wobei die mindestens eine Membran (9) nur partiell über die Flächenausdehnung des Schichtstapels in den Schichtstapel eingebracht wird.

Dabei ist es denkbar, dass die entsprechende Schicht bzw. die entsprechenden Schichten bereits vor ihrem Anordnen zur Bildung des Schichtstapels mit einer jeweiligen Öffnung versehen ist bzw. sind. Ferner ist es möglich, dass jeweils mehrere Öffnungen, ggf. dicht nebeneinander liegend, vorgesehen werden.

In einer möglichen Ausgestaltung des erfindungsgemäß vorgesehenen Verfahrens wird die Ausnehmung durch Fräsen oder Stanzen der Innenlage oder des Multilayerkerns erzeugt und durch Verpressen mit weiteren Innenlagen, Prepreg-Schichtlagen oder Multilayerkernen unter Bildung des Hohlraums einseitig öder beidseitig bis auf die vorzusehende Öffnung verschlossen.

Das Fräsen kann dabei als Durchgangsloch oder als Tiefenfräsung ausgeführt werden. Im Falle eines Durchgangslochs ist zur Abdichtung gegenüber einem Flüssigkeitseintritt ein beidseitiges Abdecken erforderlich, während bei Vorsehen einer Tiefenfräsung nur ein einseitiges Abdecken erforderlich ist.

Erfindungsgemäß ist es ebenso möglich, in dem Hohlraum einen Sensor, insbesondere einen Drucksensor oder einen Filter, insbesondere einen SAW-Filter, anzuordnen.

Mit der Erfindung lässt sich sehr einfach durch Vorsehen eines Drucksensors in dem erfindungsgemäß vorgesehenen Hohlraum im Inneren des Leiterplatten-Mehrschichtaufbaus ein Druck im Inneren des Mehrschichtaufbaus messen, wobei der dazu nötige Drucksensor platzsparend und zudem zuverlässig den herrschenden Druck messen kann.

Ferner lässt sich der mit einem Hohlraum versehene Leiterplatten-Mehrschichtaufbau effizient in der Hochfrequenztechnik einsetzen, da durch Vorsehen des Hohlraums Hochfrequenz von Schicht zu Schicht verlustarm eingekoppelt bzw. übertragen werden kann und zudem beim Gesamtaufbau einer entsprechenden Leiterplatte teures HF-Material eingespart und kostengünstige Mischaufbauten verwendet werden können.

Weitere Vorteile und Ausgestaltungen der Erfindung ergeben sich aus der Beschreibung der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Figuren ausführlich beschrieben.

### Kurzbeschreiburig der Zeichnung

Figur 1 zeigt eine schematische Schnittansicht eines Ausschnitts einer möglichen Ausführungsform des erfindungsgemäßen Leiterplatten-Mehrschichtaufbaus.
Figur 2 zeigt eine schematische Schnittansicht eines Ausschnitts einer weiteren Ausführungsform des erfindungsgemäßen Leiterplatten-Mehrschichtaufbaus.

### Detaillierte Beschreibung der Zeichnung

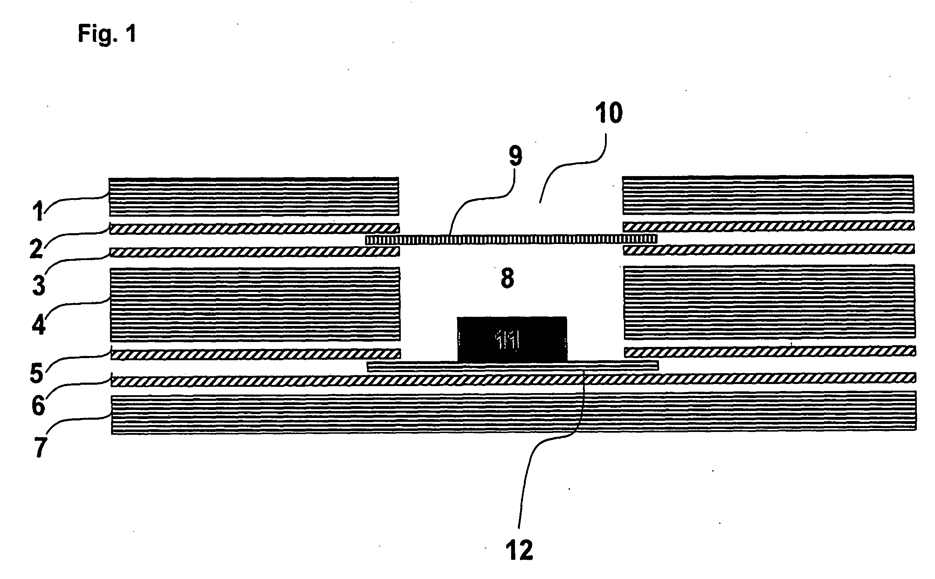

Figur 1 zeigt eine schematische Seitenansicht eines Ausschnitts einer möglichen Ausführungsform eines erfindungsgemäßen Leiterplatten-Mehrschichtaufbaus. Dargestellt sind hier insgesamt 7 Schichtlagen. Bei den Schichtlagen 1,4 und 7 kann es sich dabei jeweils um eine Innenlage handeln, wobei auf die Schichtlagen 1 und 7 jeweils entsprechend weitere, hier nicht dargestellte Schichtlagen aufgebracht sein können bzw. aufgebracht werden können. Bei der Schichtlage 4 ist es möglich, dass es sich auch um einen Multilayerkern handelt. Die mit schräger Schraffur angedeuteten Schichtlagen 2, 3, 5 und 6 sind bspw. sog. No-Flow-Prepreg-Schichtlagen oder Prepreg-Schichtlagen. Die Schichtlagen 1 bis 5 sind jeweils mit einer Ausnehmung versehen, so dass sich durch Übereinanderordnen dieser Schichten, wie in Figur 1 dargestellt, im Inneren des Leiterplatten-Mehrschichtaufbaus ein Hohlraum 8 ergibt, welcher gegenüber einem möglichen Flüssigkeitseintritt mittels einer Membran 9 abgedichtet ist. Falls auf die Schichtlage 1, wie voranstehend beschrieben, weitere Schichtlagen (hier nicht dargestellt) aufgebracht werden, so weisen diese ebenfalls je eine zu den Schichtlagen 1 bis 5 entsprechende Ausnehmung auf. Über die Öffnung 10, die durch die in den Schichtlagen 1 und 2 jeweils vorgesehene Ausnehmung gebildet wird, kann ein Druckausgleich zwischen der Umgebung des Leiterplatten-Mehrschichtaufbaus und dem Hohlraum 8 geschaffen werden. Die Membran 9 ist in der hier dargestellten Ausführungsform nur partiell über die Flächenausdehnung des Schichtstapels in den Schichtstapel eingebracht. In der hier gezeigten Ausführungsform ist die Membran 9 ferner zwischen zwei No-Flow-Prepreg- Schichtlagen, nämlich den Schichtlagen 2 und 3, einlaminiert. Es wäre auch möglich, die Membran auf eine Innenlage dicht zu kleben.

Die vorgesehene Membran 9 kann bspw. aus mikroporösem PTFE, insbesondere aus Gortex bestehen, das Gasdiffusion ermöglicht, Flüssigkeitszutritt jedoch ausschließt. Die Membran 9 kann jedoch auch aus einem anderen Material hergestellt werden, wobei darauf zu achten ist, dass das zu verwendende Material der Membran 9 haftfest geklebt oder einlaminiert werden kann und beständig gegen verwendete Medien und Vetarbeitungstemperaturen ist. Ferner darf ein Flüssigkeitszutritt durch die Membran nicht möglich sein. Weitere mögliche Materialien sind bspw. PEEK oder Polyimid.

Ferner kann auch ein Gemisch der genannten Materialien ggf. verwendet werden.

In dem Hohlraum 8 ist in der hier dargestellten Ausführungsform des erfindungsgemäßen Leiterplatten-Mehrschichtaufbaus ein Drucksensor 11 vorgesehen, mit dessen Hilfe der Druck gemessen werden kann. Durch Variation der Größe und der Dicke der Membran 9 können dabei trägere oder schnellere Messungen ermöglicht werden. Durch Vorsehen einer vergleichsweise dünnen Membran, die sich elastisch verhält, bedarf es bei schnellen Druckwechseln keiner Diffusion. Bei dicken, unelastischen Membranen hingegen wird sich ein Druckausgleich erst mit einer diffusionsbedingten Verzögerung einstellen.

In der hier gezeigten Ausführungsform ist das durch die jeweiligen Ausnehmungen in den Schichtlagen 1 bis 5 erzeugte Durchgangsloch in Richtung der in dem Schichtstapel darunterliegenden Schicht 6 durch einen Interposer 12 abgedeckt.

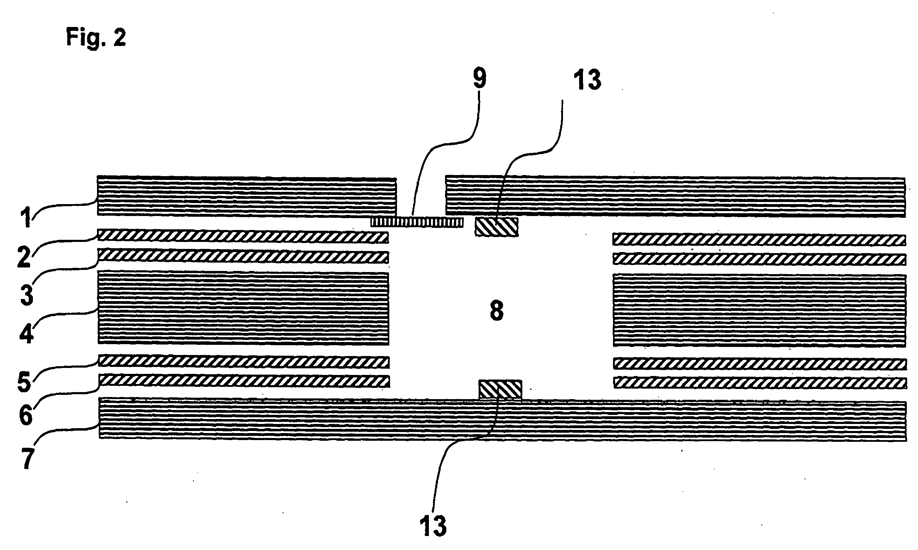

Figur 2 stellt eine schematische Seitenansicht einer weiteren Ausführungsform des erfindungsgemäßen Leiterplatten-Mehrschichtaufbaus dar. Hier ist der Leiterplatten-Mehrschichtaufbau mit einer Hochfrequenz-Koppelstruktur 13 dargestellt. Dabei sind die Schichtlagen 1 und 7 HF-Basismaterial, während die Schichtlagen 2, 3 und 5, 6 sog. No-Flow-Prepreg-Schichten sind. Die Schichtlage, in welcher der eigentliche Hohlraum vorzusehen ist, kann dabei eine. Standard-FR4-Schicht sein, die vergleichsweise zu den HF-Basismaterialschichten 1 und 7 günstig ist. Der Hohlraum 8 ist hier gebildet durch eine jeweilige Durchgangsöffnung in den Schichtlagen 2 bis 6. Der Hohlraum 8 kann optional durch eine Membran 9, die hier unterhalb von Schichtlage 1 angeordnet, bspw. angeklebt ist, gegenüber der Umgebung abgedichtet werden. Es ist auch denkbar, eine derartige Membran 9 zwischen zwei Schichtlagen, bspw. zwischen No-Flow-Prepreg-Schichten 2 und 3 einzulaminieren. Generell ist eine Membran für die Kopplung nicht erforderlich, kann jedoch bspw. aus Gründen der Verarbeitung wünschenswert oder gar vonnöten sein. Da die materialspezifische relative Dielektrizitätskonstante innerhalb des Hohlraums 8, der im wesentlichen mit Luft gefüllt ist, 1 ist, ergibt sich eine sehr gute bzw. verlustarme Einkopplung von Hochfrequenzsignalen von Lage zu Läge bzw. eine verlustarme Übertragung der entsprechenden HF-Signale. Dadurch kann teures HF-Material für den Gesamtaufbau eines entsprechenden Leiterplatten-Mehrschichtaufbaus eingespart werden und kostengünstige Mischaufbauten unter Verwendung von Standard-FR4 können realisiert werden. Die Koppelstruktur 13 sieht bspw. vor, dass eine Sendestruktur im oberen Bereich des Hohlraums 8 unterhalb von Schichtlage 1 und eine Empfangsstruktur im unteren Bereich des Hohlraums 8, bspw. direkt auf der den Hohlraum 8 abschließenden Schichtlage 7 angeordnet ist.

## Patentansprüche

1. Leiterplatten-Mehrschichtaufbau mit einem Schichtstapel aus mehreren übereinander angeordneten elektrisch isoliegenden und leitenden Schichten (1-7) und einem Hohlraum (8) im Inneren des Schichtstapels, der sich lateral nur in einem Teilbereich der Flächenausdehnung des Schichtstapels erstreckt, durch eine in dem Schichtstapel vorgesehene Öffnung einem den Leiterplatten-Mehrschichtaufbau umgebenden Druck ausgesetzt ist, **dadurch gekennzeichnet, dass** der Hohlraum (8) gegenüber einem Flüssigkeitseintritt mittels mindestens einer flüssigkeitsundurchlässigen Membran (9) gegenüber einem Flüssigkeitseintritt abgedichtet ist, wobei die mindestens eine Membran (9) zwischen Schichtlagen, insbesondere zwischen No-Flow-Prepreg-Schichtlagen einlaminiert oder auf eine Innenlage dicht/haftfest geklebt ist und wobei die mindestens eine Membran (9) nur partiell über die Flächenausdehnung des Schichtstapels in dem Schichtstapel eingebracht ist.

2. Leiterplatten-Mehrschichtaufbau nach Anspruch 1, bei dem der Hohlraum (8) durch Fräsen oder Stanzen einer Innenlage oder eines Multilayerkerns erzeugt ist und durch Verpressen mit weiteren Innenlagen, Prepreg-Schichtlagen oder Multilayerkernen einseitig oder beidseitig bis auf die vorgesehene Öffnung verschlossen ist.

3. Leiterplatten-Mehrschichtaufbau nach Anspruch 2, bei dem der Hohlraum (8) als Durchgangsloch oder als Tiefenfräsung ausgeführt ist.

4. Leiterplatten-Mehrschichtaufbau nach einem der Ansprüche 1 bis 3, bei dem die mindestens eine Membran (9) aus einem Material, welches aus der Gruppe bestehend aus mikroporösem PTFE, insbesondere Goretex, PEEK, Polyimid oder einem Gemisch derselben, gewählt ist, hergestellt ist.

5. Leiterplatten-Mehrschichtaufbau nach einem der voranstehenden Ansprüche, bei dem in dem Hohlraum (8) ein Sensor (11), insbesondere ein Drucksensor angeordnet ist.

6. Leiterplatten-Mehrschichtaufbau nach einem der Ansprüche 1 bis 4, bei dem in dem Hohlraum ein SAW-Filter angeordnet ist.

7. Leiterplatten-Mehrschichtaufbau nach einem der voranstehenden Ansprüche, wobei der Leiterplatten-Mehrschichtaufbau als HF-Koppelstruktur ausgebildet ist.

8. Verfahren zum Herstellen eines Leiterplatten-Mehrschichtaufbaus nach einem der Ansprüche 1 bis 7, mit mindestens den folgenden Schritten:
- Bereitstellen einer Innenlage oder eines Multilayerkerns,
- Erzeugen einer Ausnehmung in der Innenlage oder dem Multilayerkern,
- Anordnen der weiteren Schichten des Schichtstapels unterhalb und/oder oberhalb der mit der Ausnehmung versehenen Innenlage bzw. des mit der Ausnehmung versehenen Multilayerkerns, wodurch ein Hohlraum im Inneren des Schichtstapels gebildet wird, der sich lateral nur in einem Teilbereich der Flächenausdehnung des Schichtstapels erstreckt,
- Zusammenlaminieren und/oder Verpressen der so erhaltenen Mehrschichtanordnung,
- Jeweiliges Vorsehen mindestens einer Öffnung in einer oder mehreren der den Schichtstapel bildenden Schichten, so dass der gebildete Hohlraum einem den Leiterplatten-Mehrschichtaufbau umgebenden Druck ausgesetzt ist, und
- Abdichten des gebildeten Hohlraums gegenüber einem Flüssigkeitseintritt durch Einlaminieren mindestens einer flüssigkeitsundurchlässigen Membran (9) zwischen Schichtlagen, insbesondere zwischen No-Flow-Prepreg Schichtlagen oder durch dichtes/haftfestes Kleben der mindestens einen flüssigkeitsundurchlässigen Membran (9) auf eine Innenlage, wobei die mindestens eine Membran (9) nur partiell über die Flächenausdehnung des Schichtstapels in den Schichtstapel eingebracht wird.

9. Verfahren nach Anspruch 8, bei dem die Ausnehmung durch Fräsen oder Stanzen der Innenlage oder des Multilayerkerns erzeugt wird und durch Verpressen mit weiteren Innenlagen, Prepreg-Schichtlagen oder Multilayerkernen unter Bildung des Hohlraums einseitig oder beidseitig bis auf die vorzusehende Öffnung verschlossen wird.

10. Verfahren nach Anspruch 8 oder 9, bei dem die Ausnehmung als Durchgangsloch oder als Tiefenfräsung ausgeführt wird.

11. Verfahren nach einem der Ansprüche 8 bis 10, bei dem in dem Hohlraum ein Sensor, insbesondere ein Drucksensor, oder ein Filter, insbesondere ein SAW-Filter angeordnet wird.

## Claims

1. A printed circuit board multilayer construction, comprising a layer stack of several electrically insulating and/or conductive layers (1 - 7) arranged one above the other; and a cavity (8) in an interior of the layer stack, wherein the cavity extends laterally only into a partial region of the areal extent of the layer stack, and through an opening provided in the layer stack, is exposed to a pressure surrounding the printed circuit board multilayer construction, **characterized in that** the cavity (8) is sealed relative to ingress of liquid by means of at least one liquid-impermeable membrane (9), wherein the membrane (9) is laminated in between film layers, in particular in between no-flow prepreg layers, or is tightly/firmly glued to an inner film, and wherein the at least one membrane (9) is inserted in the layer stack only partially over the areal extent of the layer stack.

2. The printed circuit board multilayer construction according to claim 1, in which the cavity (8) is produced by milling or stamping of an inner film or of a multilayer core and by sandwiching with further inner films, prepreg layers or multilayer cores, and is closed on one side or on both sides except the provided opening.

3. The printed circuit board multilayer construction according to claim 2, in which the cavity (8) is embodied as a through hole or as a depth milling.

4. The printed circuit board multilayer construction according to any one of claims 1 to 3, in which the at least one membrane (9) is produced from a material selected from the group comprising microporous PTFE, in particular Goretex, PEEK, polyimide or a mixture thereof.

5. The printed circuit board multilayer construction according to any one of the preceding claims, in which a sensor (11), in particular a pressure sensor, is arranged in the cavity (8).

6. The printed circuit board multilayer construction according to any one of claims 1 to 4, in which a SAW filter is arranged in the cavity.

7. The printed circuit board multilayer construction according to any one of the preceding claims, wherein the printed circuit board multilayer construction is embodied as an HF coupling structure.

8. A method for producing a printed circuit board multilayer construction according to any one of claims 1 to 7, comprising at least the following steps:
- providing an inner film or a multilayer core;
- producing a cutout in the inner film or the multilayer core;
- arranging the further layers of the layer stack below and/or above the inner film provided with the cutout or the multilayer core provided with the cutout, whereby a cavity is formed in the interior of the layer stack, wherein the cavity extends laterally only in a partial region of the areal extent of the layer stack;
- laminating together and/or sandwiching the multilayer arrangement thus obtained;
- individually providing at least one opening in one or more of the layers forming the layer stack so that the cavity formed is exposed to a pressure surrounding the printed circuit board multilayer construction; and
- sealing the cavity formed relative to ingress of liquid by laminating at least one liquid-impermeable membrane (9) in between film layers, in particular in between no-flow prepreg layers, or by tightly/firmly glueing of the at least one liquid-impermeable membrane (9) to an inner film, wherein the at least one membrane (9) is inserted in the layer stack only partially over the areal extent of the layer stack.

9. The method according to claim 8, in which the cutout is produced by milling or stamping of the inner film or of the multilayer core and, by sandwiching with further inner films, prepreg layers or multilayer cores, and forming the cavity, is closed on one side or on both sides except the provided opening.

10. The method according to claim 8 or 9, in which the cutout is carried out as a through hole or as a depth milling.

11. The method according to any one of claims 8 to 10, in which a sensor, in particular a pressure sensor, or a filter, in particular a SAW filter, is arranged in the cavity.

## Revendications

1. Structure multicouche pour carte à circuits comprenant un empilement de couches constitué de plusieurs couches électriquement isolantes et électriquement conductrices (1-7) agencées les unes au-dessus des autres, et d'une cavité (8) à l'intérieur de l'empilement de couches, qui s'étend latéralement uniquement dans une région partielle de l'extension surfacique de l'empilement de couches, qui est exposée, à travers une ouverture prévue dans l'empilement de couches, à une pression aux alentours de la structure multicouches pour cartes à circuits, **caractérisée en ce que** la cavité (8) est étanchée à l'encontre d'une pénétration de liquide, au moyen d'au moins une membrane (9) imperméable aux liquides, dans laquelle ladite au moins une membrane (9) est intégrée par stratification entre des nappes de couches, en particulier entre des nappes de couches de préimprégnés de type "No-Flow", ou est collé de manière étanche et en adhésion ferme sur une couche intérieure, et dans laquelle ladite au moins une membrane (9) est intégré dans l'empilement de couches uniquement partiellement sur l'extension surfacique de l'empilement de couches.

2. Structure multicouche pour carte à circuits selon la revendication 1, dans laquelle la cavité (8) est engendrée par fraisage ou poinçonnage d'une couche intérieure ou d'un noyau multicouche, et est refermée par pressage avec d'autres couches intérieures, d'autres nappes de couches de préimprégnés ou d'autres noyaux multicouches, sur un côté ou sur les deux côtés, à l'exception de l'ouverture prévue.

3. Structure multicouche pour carte à circuits selon la revendication 2, dans laquelle la cavité (8) est réalisée sous forme de trou traversant ou sous forme de fraisage en profondeur.

4. Structure multicouche pour carte à circuits selon l'une des revendications 1 à 3, dans laquelle ladite au moins une membrane (9) est fabriquée en un matériau qui est choisi parmi le groupe constitué du PTFE microporeux, en particulier Goretex, PEEK, polyimide, ou un mélange de ceux-ci.

5. Structure multicouche pour carte à circuits selon l'une des revendications précédentes, dans laquelle un capteur (11), en particulier un capteur de pression, est agencé dans la cavité (8).

6. Structure multicouche pour carte à circuits selon l'une des revendications 1 à 4, dans laquelle un filtre SAW est agencé dans la cavité.

7. Structure multicouche pour carte à circuits selon l'une des revendications précédentes, dans laquelle la structure multicouche pour carte à circuits est réalisée sous forme de structure de couplage HF.

8. Procédé pour fabriquer une structure multicouche pour carte à circuits selon l'une des revendications 1 à 7, comprenant au moins les étapes suivantes :
- on prépare une nappe intérieure ou un noyau multicouche,
- on engendre un évidement dans la nappe intérieure ou dans le noyau multicouche,
- on agence les autres couches de l'empilement de couches au-dessous et/ou au-dessus de la nappe intérieure dotée de l'évidement ou respectivement du noyau multicouche doté de l'évidement, grâce à quoi il se forme une cavité à l'intérieur de l'empilement de couches, qui s'étend latéralement uniquement dans une région partielle de l'extension surfacique de l'empilement de couches,
- on stratifie ensemble et/ou on presse l'agencement multicouche ainsi obtenu,
- on prévoit respectivement au moins une ouverture dans une ou plusieurs des couches qui forment l'empilement de couches de telle façon que la cavité formée soit exposée à une pression environnante de la structure multicouche pour carte à circuits, et
- on étanche la cavité formée à l'encontre d'une pénétration de liquide par intégration par stratification d'au moins une membrane imperméable aux liquides (9) entre des nappes de couches, en particulier entre des nappes de couches de préimprégnés de type "No-Flow) ou par collage étanche/à ferme adhésion de ladite au moins une membrane imperméable liquide (9) sur une nappe intérieure, et dans laquelle ladite au moins une membrane (9) est intégrée uniquement partiellement dans l'empilement de couches sur l'extension surfacique de l'empilement de couches.

9. Procédé selon la revendication 8, dans lequel l'évidement est produit par fraisage ou par poinçonnage de la nappe intérieure ou du noyau multicouche et est refermé par pressage avec d'autres nappes intérieures, d'autres nappes de couches de préimprégnés, où d'autres noyaux multicouches en formant la cavité, d'un côté ou sur les deux côtés à l'exception de l'ouverture à prévoir.

10. Procédé selon la revendication 8 ou 9, dans lequel l'évidement est réalisé sous forme de trou traversant ou sous forme de fraisage profond.

11. Procédé selon l'une des revendications 8 à 10, dans lequel un capteur, en particulier un capteur de pression, ou un filtre, en particulier un filtre SAW, est agencé dans la cavité.
